# EUROPEAN PATENT SPECIFICATION

(11) **EP 0 962 974 B1**
(45) Date of publication and mention of the grant of the patent: **26.01.2005**
(21) Application number: 99303988.2
(22) Date of filing: 24.05.1999
(51) Int. Cl.: H01L 23/24, H01L 25/07

(54) **Semiconductor device**
Halbleiteranordnung
Dispositif semi-conducteur

(30) Priority: 28.05.1998 JP 14689698; 20.01.1999 JP 1146599
(43) Date of publication of application: 08.12.1999
(73) Proprietor: Hitachi, Ltd., Chiyoda-ku, Tokyo 101 (JP)
(72) Inventor: Kushima, Tadao, Naka-gun, Ibaraki 319-1114 (JP); Tanaka, Akira, Mito-shi, Ibaraki 310-0836 (JP); Saito, Ruyuichi, Hitashi-shi, Ibaraki 319-1225 (JP); Suzuki, Kazuhiro, Mito-shi, Ibaraki 310-001 (JP); Koike, Yoshihiko, Hitachinaka-shi, Ibaraki 312-0001 (JP); Shimizu, Hideo, Mito-shi, Ibaraki 310-0911 (JP)
(74) Representative: Calderbank, Thomas Roger

(56) References cited:
- EP-A- 0 921 565
- DE-A- 3 309 679
- PATENT ABSTRACTS OF JAPAN vol. 018, no. 673 (E-1647), 19 December 1994 (1994-12-19) -& JP 06 268094 A (SANYO ELECTRIC CO LTD), 22 September 1994 (1994-09-22)
- PATENT ABSTRACTS OF JAPAN vol. 1996, no. 09, 30 September 1996 (1996-09-30) -& JP 08 125071 A (FUJI ELECTRIC CO LTD), 17 May 1996 (1996-05-17)
- PATENT ABSTRACTS OF JAPAN vol. 010, no. 228 (E-426), 8 August 1986 (1986-08-08) -& JP 61 064144 A (MITSUBISHI ELECTRIC CORP), 2 April 1986 (1986-04-02)
- PATENT ABSTRACTS OF JAPAN vol. 1995, no. 03, 28 April 1995 (1995-04-28) -& JP 06 334070 A (SANYO ELECTRIC CO LTD), 2 December 1994 (1994-12-02)

## Description

The present invention relates to a semiconductor device in which a case of the semiconductor device contains semiconductor elements and is filled with resin.

As a conventional semiconductor device similar to the semiconductor device of the present invention, a power semiconductor device is disclosed in Japanese Patent Application Laid-Open Hei 8-125071. Fig. 10 shows a cross-sectional view showing the schematic composition of the conventional power semiconductor device. A ceramic substrate 3a, on whose top and back surfaces copper sheets 3b are attached, is soldered to a metal base plate 1, and a leader-line terminal is led out from the copper sheet 3b attached on the top surface of the ceramic substrate 3a. The peripheral part of the ceramic substrate (insulating substrate) 3a is covered with silicone rubber adhesive 14, and the insulating substrate 3a is contained in a case 6, and is covered with gel silicone rubber 5b poured into the case 6. A space among a terminal block 8, the gel silicone rubber 5b, and the case 6 is sealed with epoxy resin 15.

In this conventional semiconductor device, the silicone rubber adhesive 14 covering the peripheral part of the ceramic substrate 3a prevents the decrease of the creepage withstand voltage of the substrate 3a.

The subjects in the conventional semiconductor device are as follows.

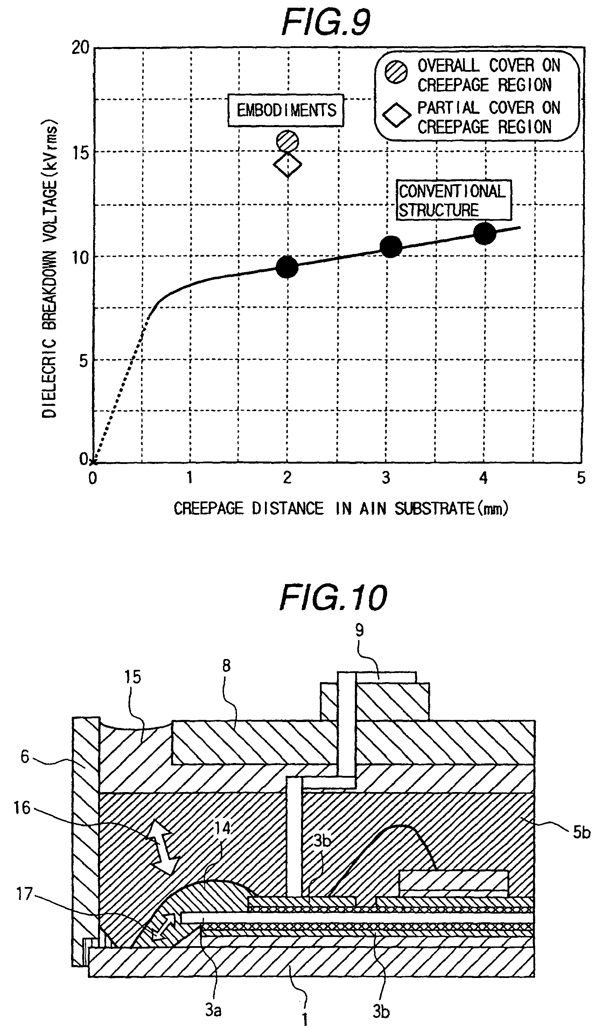

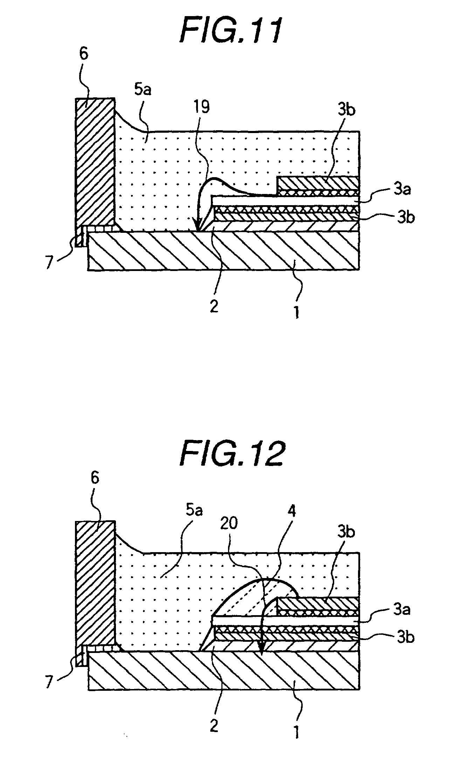

First, since the gel silicone rubber 5b is sealed with the epoxy resin 15, if the gel silicone rubber 5b expands and contracts during the operation of the semiconductor device, a separation defect occurs at the interface between the gel silicone rubber 5b and the silicone rubber adhesive 14 as shown in Fig. 11, which is due to the internal stress 16 shown by the arrow mark 16 in Fig. 10. This separation defect will cause a dielectric breakdown of the ceramic substrate 3a.

Secondly, expansion and contraction of the silicone rubber adhesive 14, which is shown by the arrow mark 17, may bend and break the peripheral part of the ceramic substrate 3a. If the ceramic substrate 3a is broken, the creepage distance between the base plate 1 and the copper sheet attached on the surface of the ceramic substrate 3a decreases, which degrades the withstand voltage of the semiconductor device.

JP-A-06-268094 discloses a semiconductor device in which an insulating plate is mounted in a base plate, and is surrounded by a case. The insulating plate has a conductive layer thereon and supports semiconductor elements. The case is filled with silicon gel and there is a second resin on the peripheral part of the insulating plate. Thus this document corresponds to the pre-characterising part of claim 1.

JP-A-8-125071 discloses a semiconductor device in which semiconductor elements are mounted on an insulating plate, and the edge of that plate is covered with a silicone rubber adhesive to prevent insulation failure.

According to the present invention there is provided a semiconductor device comprising the features of claim 1.

### IN THE DRAWINGS

Fig. 1 is a partial cross-sectional view of a module-type power semiconductor device useful for understanding the present invention.

Fig. 2 is a plan view of semiconductor circuits composed on an aluminum nitride substrate in the device shown in Fig. 1.

Fig. 3 is a cross-sectional view showing the whole composition of the semiconductor device shown in Fig. 1.

Fig. 4 is a plan view of semiconductor circuits composed on an aluminum nitride substrate in a power semiconductor device useful for understanding the present invention.

Fig. 5 is a perspective plan view of semiconductor circuits composed on an aluminum nitride substrate in a power semiconductor device of an embodiment according to the present invention.

Fig. 6 is a partial cross-sectional view of the semiconductor device of the embodiment shown in Fig. 5.

Fig. 7 is a partial cross-sectional view of a module-type power semiconductor device useful for understanding the present invention.

Fig. 8 is a partial cross-sectional view of a module-type power semiconductor device useful for understanding the present invention.

Fig. 9 shows the relationship between the dielectric breakdown voltage and the creepage distance in the aluminum nitride substrate in the power semiconductor device of the embodiment.

Fig. 10 is a cross-sectional view showing the composition of a conventional power semiconductor.

Fig. 11 is a conceptual illustration showing the dielectric breakdown mechanism in the conventional semiconductor device.

Fig. 12 is a conceptual illustration showing the dielectric breakdown mechanism in the conventional semiconductor device of the embodiment according to the present invention.

Fig. 13 is a partial cross-sectional view of a power semiconductor device useful for understanding the present invention.

Fig. 14 is a plan view of semiconductor circuits composed on an aluminum nitride substrate in the device shown in Fig. 13.

Fig. 15 is a cross-sectional view showing the whole composition of the semiconductor device shown in Fig. 13.

Fig. 16 is a partial cross-sectional view of a power semiconductor device useful for understanding the present invention.

Fig. 17 is a partial cross-sectional view of a power semiconductor device of another embodiment according to the present invention.

Fig. 18A is a perspective view of the insulating resin frame in the semiconductor device of the embodiment shown in Fig. 17.

Fig. 18B is a cross-sectional view of the insulating resin frame and the insulating substrate mounted on the base plate in the semiconductor device of the embodiment shown in Fig. 17.

Fig. 19 is a cross-sectional view of a modified insulating resin frame and the insulating substrate mounted on the base plate, corresponding to Fig. 18B.

Fig. 20 is a partial cross-sectional view of a power semiconductor device useful for understanding the present invention.

Fig. 21 is a plan view of semiconductor circuits composed on an aluminum nitride substrate in the power semiconductor device of the device shown in Fig. 20.

Fig. 22 is a partial cross-sectional view of a power semiconductor device useful for understanding the present invention.

Fig. 23 is a partial cross-sectional view of a power semiconductor device useful for understanding the present invention.

Fig. 24 is a partial cross-sectional view of a power semiconductor device useful for understanding the present invention.

Fig. 25 is a partial cross-sectional view of a power semiconductor device of another embodiment according to the present invention.

Fig. 26 is a diagram tabling properties of various kinds of non-organic glass and resin.

Hereafter, details of the embodiments according to the present invention will be explained with reference to the drawings.

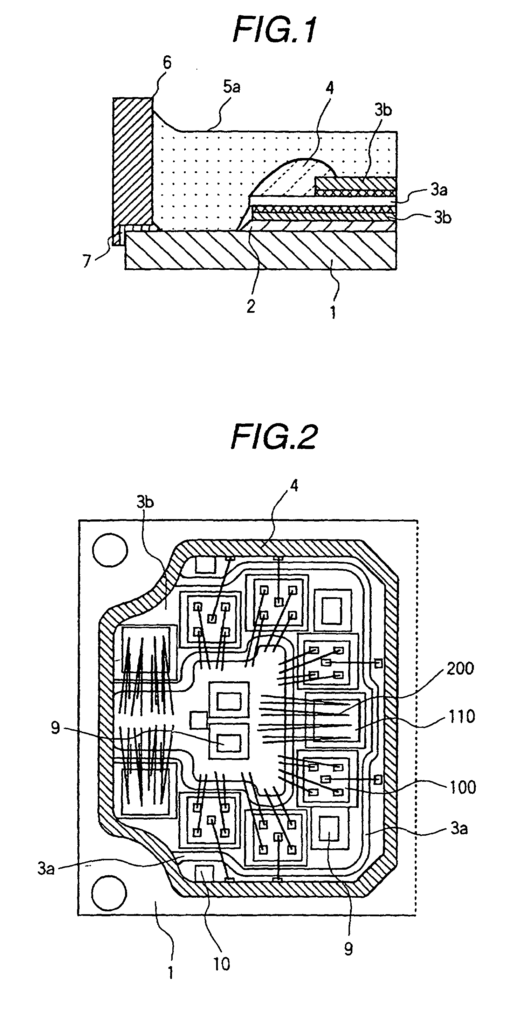

Fig. 1 is a partial cross-sectional view of a module-type power semiconductor device.

As shown in Fig. 1, an insulating ceramic substrate 3a such as an aluminum nitride (AlN) substrate, on whose top and back surface thin copper sheets 3b are attached, is mounted on a metal base plate 1 made of Al-SiC. The back surface of the aluminum nitride substrate 3a is facing the top surface of the base plate 1, and the thin copper sheet 3b attached on the back surface of the aluminum nitride substrate 3a is connected to the top surface of the base plate 1 with solder 2 such as (Sn-40%Pb) solder. The peripheral edge part of the base plate 1 is adhered to the inside of an insulating resin case 6 with adhesive 7. The case 6 is filled with silicone insulating-gel resin 5a so that the gel resin 5a covers the aluminum nitride substrate 3a, the thin copper sheets 3b attached on the top and back surfaces of the substrate 3a, and silicone-resin 4, which will be explained later, covering the peripheral part of the substrate 3a.

In this device, the surface of the aluminum nitride 3a, between the peripheral edge part of the aluminum nitride substrate 3a and the edge part of the thin copper sheet 3b attached on the substrate 3a, is covered with silicone-resin 4 as shown in Fig. 1. Moreover, the withstand voltage (21 kVrms/mm) of the silicone-resin 4 is higher than that (14 kVrms/mm) of the insulating-gel resin 5a. Accordingly, the creepage withstand voltage of the aluminum nitride substrate 3a is improved in comparison with the semiconductor device in which the aluminum nitride substrate 3a is covered by only the insulating-gel resin 5a. Further, the withstand voltage of the siclicone-resin 4 is higher than that (10 - 13 kVrms/mm) of the aluminum nitride substrate 3a. Furthermore, since the distance between the peripheral edge of the aluminum nitride substrate 3a and the edge of the thin copper sheet 3b attached on the substrate 3a is larger than the thickness of the aluminum nitride substrate 3a, the thickness of the silicone-resin 4 in the creepage direction is larger than the thickness of the aluminum nitride substrate 3a. Therefore, the dielectric breakdown voltage of the silicone-resin in the creepage direction is higher than the that of the aluminum nitride substrate 3a. Thus, since the dielectric breakdown hardly occurs on the creepage surface, and depends on only the aluminum nitride substrate 3a, the dielectric breakdown voltage can be easily determined and set.

Additionally, the edge and the part near the edge of the thin copper sheet 3b attached on the substrate 3a are also covered with the silicone-resin 4. Therefore, the part of high potential strength in the copper sheet 3b is covered with the silicone-resin 4, which also improves the creepage withstand voltage.

Further still, the edge part of the silicone-resin 4 at the peripheral edge of the aluminum nitride substrate 3a is located within the peripheral surface of the substrate 3. That is, the silicone-resin 4 does not contact the surface of the base plate 1, between the connection part of the case 6 and the base plate 1, and the end side of the connection area of the base plate 1 and the substrate 3a. Therefore, even if the inner stress is generated between the silicone-resin 4 and the base plate 1 by the internal stress in the silicone-resin 4, due to expansion and contraction of the insulating-gel resin 5a or the silicone-resin 4, the stress is not generated between the base plate 1 and the silicone-resin 4. Accordingly, since the stress generated among the silicone-resin 4, the insulating-gel resin 5a, and the aluminum nitride substrate 3a is mitigated, a separation between the silicone-resin 4 and the insulating-gel resin 5a, or the breakdown of the aluminum nitride substrate 3a, does not easily occur. Thus, in this power semiconductor device, the withstand voltage does not easily decrease, which improves the reliability of the power semiconductor device.

Fig. 2 is a plan view of semiconductor circuits composed on an aluminum nitride substrate in the embodiment shown in Fig. 1. A plurality of thin copper sheets 3b are attached on the aluminum nitride substrate 3a. Further, semiconductor chips of power semiconductor elements such as IGBTs 100, diodes 110, etc., leader-line main terminals 9, leader-line auxiliary terminals 10, and so on are soldered on the copper sheets 3b. Further, the copper sheet to which the leader-line main terminals 9 are soldered is electrically connected to each semiconductor chip with aluminum wires 200. The whole peripheral surface zone of the aluminum nitride substrate 3a is continuously covered with the silicone-resin 4. Accordingly, in the whole peripheral zone of the aluminum nitride substrate 3a, the creepage withstand voltage is increased, and the withstand voltage does not easily decrease. Thus, the reliability of the withstand voltage of the power semiconductor can be greatly improved.

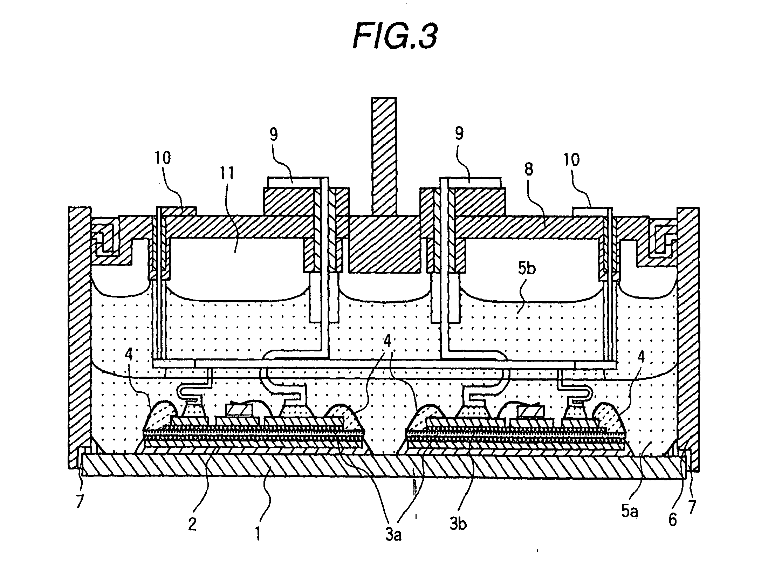

Fig. 3 is a cross-sectional view showing the whole composition of the semiconductor device shown in Fig. 1. A plurality of the aluminum nitride substrates 3a shown in Fig. 1 and Fig. 2 are soldered on the base plate 1, and the leader-line main and auxiliary terminals 9 and 10 are led out. Further, the leader-line main and auxiliary terminals 9 and 10 are passed through a terminal block 8, and a part of each of the leader-line main and auxiliary terminals 9 and 10, which is exposed outside the case 6, is connected to external circuits. Moreover, the resin member of the case 6 is connected to the peripheral edge of the base plate 1. The terminal block 8 is also a cover of the case 6. That is, the aluminum nitride substrates 3a, the leader-line main and auxiliary terminals 9 and 10, and the power semiconductor elements are contained in the case 6. Further, the insulating-gel resin 5a is poured into the case 6, and the gel resin 5a covers the aluminum nitride substrates 3a, the copper sheets 3b attached on the substrates 3a, the connection parts of the copper sheets 3b and the leader-line main and auxiliary terminals 9 and 10, the power semiconductor elements, and the silicone-resin 4. Furthermore, the second-layer of insulating-gel resin 5b is poured on the first layer of the insulating-gel resin 5a. By pouring the insulating-gel resin into the case 6 twice to form the two layers, the void due to bubbles does not easily generate in the vicinity of the aluminum nitride substrates 3a, the copper sheets 3b attached on the substrates 3a, the connection parts of the copper sheets 3b, and the leader-line main and auxiliary terminals 9 and 10, the power semiconductor elements, and the surface of the silicone-resin 4 in the insulating-gel resin. Also, there is a space 11 between the terminal block 8 and the second-layer of the insulating-gel resin 5b in the case 6. Therefore, even if the insulating-gel resin layers 5a and 5b expand, since the space 11 absorbs the expansion of the resin layers 5a and 5b, the terminal block 8 is not pressed by the insulating-gel resin layers 5a and 5b. Accordingly, the stress in the silicone-resin 4, due to the expansion and contraction of the insulating-gel resin 5a and 5b, can be mitigated, which is effective to suppress the decrease in the withstand voltage of the power semiconductor device.

The semiconductor circuits in the case 6 is composed as follows. First, the semiconductor chips are attached on the aluminum nitride substrates 3a with high melting point solder such as (Pb-5wt%Sn-1.5wt%Ag) solder by heating the chips and the solder at 350 °C in an H₂ ambience, and wiring is further performed for the chips by an aluminum bonding method. Afterward, the aluminum nitride substrates 3a are fixed on the base plate 1 with low melting point solder (for example, (Sn-40wt%Pb) solder by heating the substrates 3a and the solder at 240 °C in an H₂ ambience. Next, the silicone-resin 4 is applied to the whole peripheral zone of each aluminum nitride substrate 3a, between the edge part of the copper sheet 3b and the peripheral part of the substrate 3a, by using equipment such as a dispenser. Here, this process should be performed so that the silicone-resin 4 does not flow out on the base plate 1. Further, the applied silicone-resin 4 is heated at 150 °C for one hour in a thermostatic chamber to cure the resin 4. Furthermore, the leader-line main and auxiliary terminals 9 and 10 are soldered to the copper sheets 3b attached on the aluminum nitride substrates 3a, and the insulating resin case 6 is adhered to the peripheral of the base plate 1. Last, the insulating-gel resin 5a and 5b are poured into the case 6, and the fabrication of the semiconductor device is completed by heating and curing the insulating-gel resin layers 5a and 5b after the degassing process has been performed for the poured gel resin.

Fig. 9 shows the relationship between the dielectric breakdown voltage and the creepage distance in the aluminum nitride (AlN) substrate in this power semiconductor device, or in the conventional semiconductor device. As shown in Fig. 9, even if the creepage distance in the AlN substrate is the same that in the conventional structure, the dielectric breakdown voltage can be greatly improved. Moreover, the improvement effect is larger than the effect obtained by geometrically lengthening the creepage distance. As shown in Fig. 11, in the conventional structure, the dielectric breakdown occurs in the bulk of the insulating-gel resin 5a, or at the interface between the aluminum nitride substrate 3a and the insulating-gel resin 5a. On the other hand, in this semiconductor device , the dielectric breakdown occurs in the silicone-resin 4 or the bulk of the aluminum nitride substrate 3a. This difference between the above two types of mechanisms in the dielectric breakdown causes the difference between the dialectic voltage values in the semiconductor device of this embodiment and the conventional semiconductor device.

The above-described device can be modified as follows.

For example, in the structure shown in Fig. 1, a protrusion of the silicone-resin 4 from the periphery of the aluminum nitride substrate 3a is permitted if the protrusion does not contact the surface of the base plate 1, between the connection part of the case 6 and the base plate 1, and the connection part of the aluminum nitride substrate 3a and base plate 1. Also, the silicone-resin 4 can be replaced with material whose withstand voltage is higher than that of the substrate 3a, such as polyamide-resin whose withstand voltage is about 230 kVrms, polyimide-resin whose withstand voltage is about 200 kVrms, and the like. Further, an insulating substrate made of alumina, or other kind of resin can be also used in place of the aluminum nitride substrate 3a. Moreover, for thin conductive plates attached on the top and back surfaces, other metal or alloy other than copper can be used if it is conductive. Further still, brazing filler metal other than solder can be used to connect the aluminum nitride substrate 3a, the base plate 1, and to connect the copper sheet 3b, the semiconductor elements, and the leader-line terminals 9 and 10. Furthermore, since Al-SiC is used for the base plate in Fig. 1 so as to prevent the degradation in the electrical characteristics of the semiconductor device due to thermal stress by reducing the difference between the thermal expansion coefficients of the semiconductor material and the base plate 1, the base plate 1 can be also made of Mo or W. Additionally, to improve the heat dissipation performance of the base plate 1, other metal such as copper or alloy can be used for the base plate 1. Meanwhile, in addition to IGBTs and diodes described in this embodiment, various types of semiconductor elements such as power transistors, MOSFETs, thyristors, and so on can be mounted on the substrates 23a in the case 6. Further, these semiconductor elements can be mounted on another substrate other than the aluminum nitride 3a and contained in the case 6. The above modifications are applicable to embodiments according to the present invention.

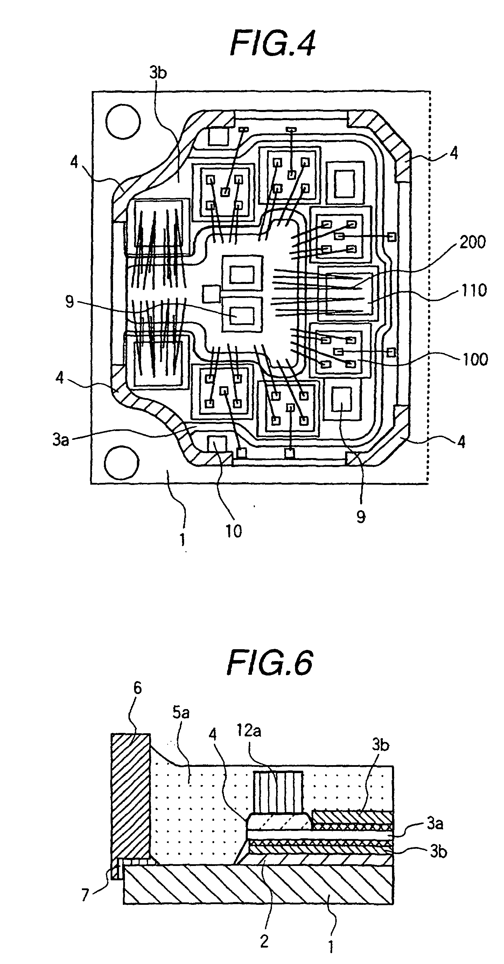

Fig. 4 is a plan view of semiconductor circuits composed on the aluminum nitride substrate 3a in another power semiconductor device. In this device, partial regions including at least corner parts in the peripheral zone of the aluminum nitride substrate 3a, at which the probability of the dielectric breakdown is comparatively high, are covered with the silicone-resin 4. This point is different from the device shown in Fig. 2. This arrangement can also increase the dielectric breakdown voltage as shown in Fig. 9. Thus, since the area to which the amount of the silicone-resin 4 is applied can be reduced, the time necessary to apply the silicone-resin 4 can be reduced, which improves the fabrication efficiency of the semiconductor devices, and the unevenness in the resin application can be also suppressed, which improves the yield of the semiconductor devices with a high dielectric breakdown voltage.

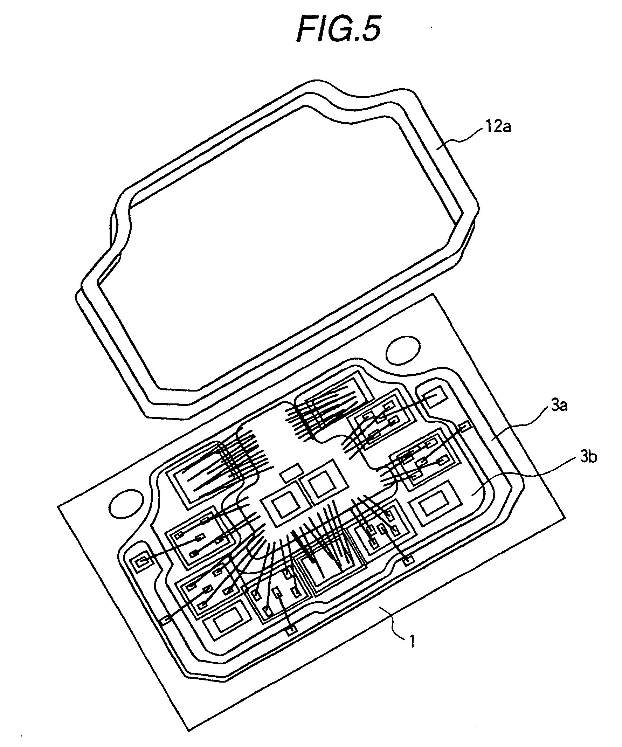

Fig. 5 is a perspective plan view of semiconductor circuits composed on the aluminum nitride substrate 3a in another power semiconductor device being an embodiment of the invention. A frame 12a, which is made of insulating resin such as PPS (poly phenylene sulfide), with an outline sectional shape equal to that of the peripheral zone in the aluminum nitride substrate 3a, is fabricated, and adhered to the peripheral zone in the aluminum nitride substrate 3a with the silicone-resin 4.

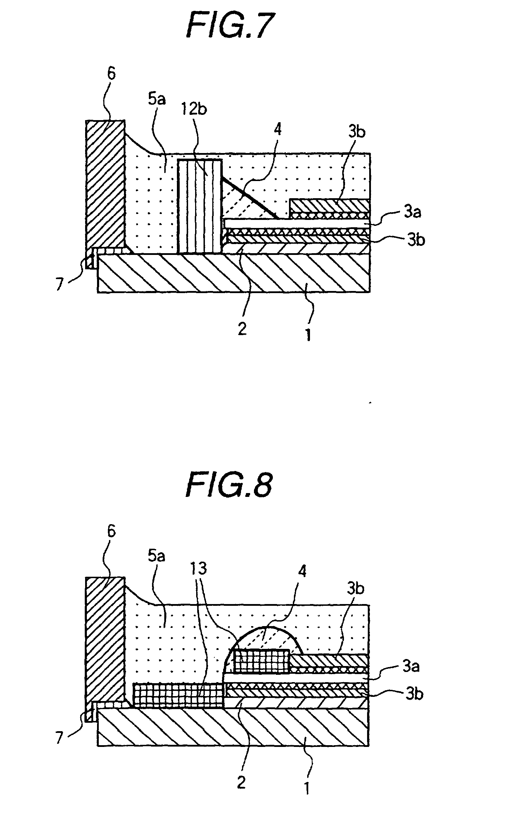

Fig. 6 is a partial cross-sectional view of the semiconductor device of the embodiment shown in Fig. 5. The PPS-resin frame 12a is adhered to the peripheral zone in the aluminum nitride substrate 3a, between the periphery edge of the substrate 3a and the edge part of the copper sheet 3a attached on the substrate 3a with the silicone-resin 4 also covering the peripheral zone. That is, the semiconductor device of this embodiment has the structure in which the PPS-resin frame 12a is attached on the silicone-resin 4 described in the embodiment shown in Fig. 1. According to this embodiment, the creepage distance in the aluminum nitride substrate 3a is practically increased by this PPS-resin frame 12a. Accordingly, the withstand voltage between the base plate 1 and the aluminum nitride substrate 3a is increased. Moreover, a frame made of other insulating material such as ceramics can be used in place of the PPS-resin frame 12a.

Fig. 7 is a partial cross-sectional view of another power semiconductor device. In this device, by using a PPS-resin frame 12b, the creepage distance in the aluminum nitride substrate 3a can be practically increased similar in the embodiment shown in Fig. 6. However, the inside shape of the frame 12b is equal to the periphery shape of the substrate 3a, and the frame 12b is adhered on the surface of the base plate 1, different from the frame 12a of the embodiment shown in Fig. 6. The aluminum nitride substrate 3a is surrounded by the frame 12b, and is soldered on the base plate 1. Furthermore, in this device as well as the above embodiment, the surface of the aluminum nitride substrate 3a, between the peripheral part of the substrate 3a and the edge part of the copper sheet 3b attached on the substrate 3a, is covered with the silicone-resin 4. Moreover, the inside wall of the PPS-resin frame 12b is adhered to the edge surface of the substrate 3a with the silicone-resin 4, and is supported by the substrate 3a. Thus, the creepage distance is secured by the PPS-resin frame 12b and the silicone-resin 4. In this embodiment also, a frame made of other insulating material such as ceramics can be used in place of the PPS-resin frame 12b.

Fig. 8 is a partial cross-sectional view of another power semiconductor device. In this device, an insulating resin sheet 13 such as a polyimide-film is adhered on the surface of the aluminum nitride substrate 3a, between the peripheral part of the substrate 3 and the edge of the copper sheet 3b attached on the substrate 3. Furthermore, the creepage region between the peripheral part of the substrate 3 and the edge of the copper sheet 3b attached on the substrate 3, which also includes the surface of the resin sheet 13, is further covered with the silicone-resin 4. Thus, the creepage distance can be increased by only a little of the silicon-resin 4 along with the effects of the resin sheet 13 adhered on the creepage region of the aluminum nitride substrate 3a. In addition, the surface of the base plate 1, outside the aluminum nitride substrate 3a, is also covered with the insulating resin sheet 13. This insulating resin sheet 13 covers the solder in the connection part of the base plate 1 and the aluminum nitride substrate 3a, and the copper sheet attached on the back surface of the substrate 3a. Further still, although not shown in Fig. 8, even if solder protrudes or projects from the connection part, the protruding or projecting solder is covered with the resin sheet 13. Therefore, the creepage distance is further increased, which also increases the withstand voltage of the substrate 3.

In the above devices, an insulating module-type power semiconductor device with a withstand voltage of more than 4500V can be obtained. For example, IGBT modules with the a withstand voltage of 5000V - 6000V can be obtained. Thus, an IGBT inverter for high-voltage power conversion can be composed with the IGBT modules of the present invention. Moreover, since the number of the IGBT modules which are serially connected can be reduced, the size of the IGBT inverter can be also decreased.

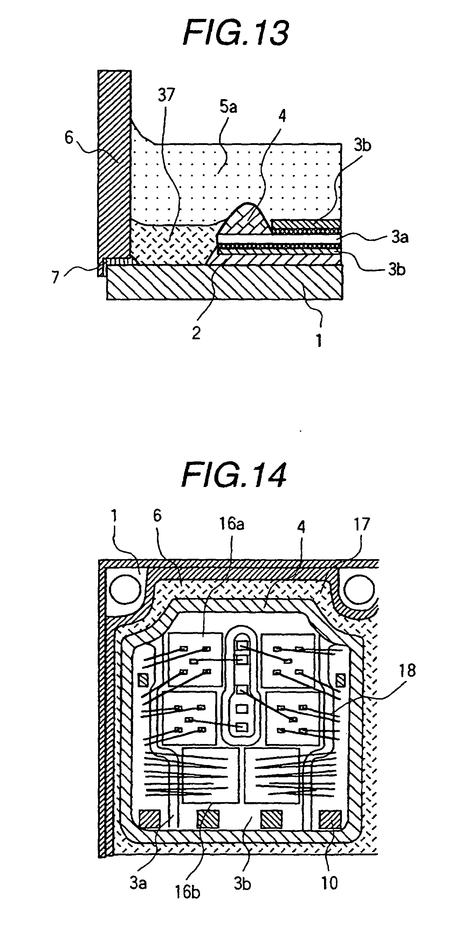

In the following, other devices will be explained with reference to Fig. 13 - Fig. 19.

Fig. 13 is a partial cross-sectional view of a power semiconductor device.

As shown in Fig. 13, the insulating substrate 3a made of insulating materiel such as aluminum nitride (AIM), on which the electrode pattern sheet 3b (for example, a copper film) is attached, is mounted on the base plate 1 made of metal such as Mo, composite material such as Al-SiC, or sintered material such CuCuO₂, with solder 2, for example, (Sn-40wt%Pb) solder. Further, the region of the insulating substrate 3a, between the edge part of the substrate 3a and the edge part of the electrode pattern sheet 3b, - that is, the creepage surface in the peripheral part of the substrate 3a -, is covered with resin 4 possessing a high withstand voltage higher than that of insulating-gel material such as silicone-gel resin whose dielectric breakdown voltage is 14 kVrms. For example, silicon-resin whose dielectric breakdown voltage is 21 kvrms, polyamide-resin whose dielectric breakdown voltage is 230 kVrms, etc., can be used for the resin 4. Moreover, a case member 6 made of insulating resin is adhered to peripheral part of the base plate 1 with adhesive 7. Further, the surface of the base plate 1, between the case member 6 and the peripheral part of the substrate 3a, is covered with another resin 37 possessing a high withstand voltage, and the insulating-gel material 5a is poured on the substrate 3, the silicon-resin 4, and the resin 37 in the case member 6. Also, the resin 37 with a high withstand voltage is poured into the case member 6 until the resin 37 contacts the inside wall of the case member 6, the insulating substrate 3a, and the resin 4 with a high withstand voltage. Accordingly, the surface of the base plate 1 is filled with the resin 37 without any opening. The same kind or different kinds of resin can be used for the resin 4 and 37 with a high withstand voltage if the resin to be used possesses the dielectric breakdown voltage higher than that of the insulating-gel material 5b.

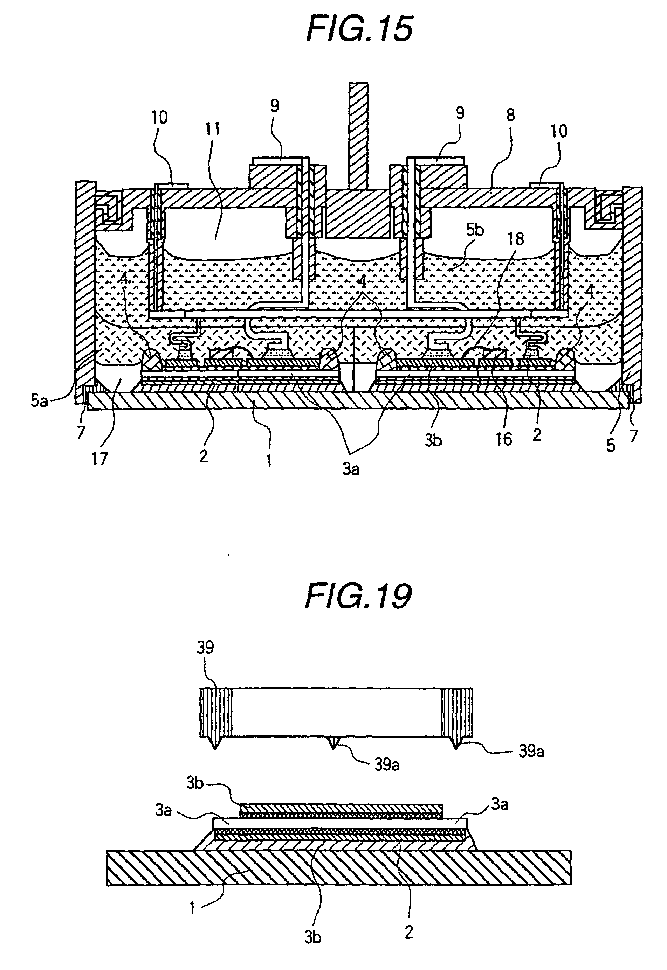

Fig. 14 is a plan view of semiconductor circuits composed on an aluminum nitride substrate in the device shown in Fig. 13, and Fig. 15 is a cross-sectional view showing the whole composition of the semiconductor device shown in Fig. 14.

A cover method using the resin 4 with a high withstand voltage shown in Figs. 13, 14, and 15 is explained below. As shown in Fig. 14 which is an enlarged plan view of the composition of semiconductor circuits mounted on one insulating substrate, the semiconductor chips 16a and 16b are attached on the insulating substrate 3a with high melting point solder such as (Pb-5wt%Sn-1.5w%Ag) solder with the melting point of 296 - 305 °C by heating the chips and the solder at 350 °C in an H₂ ambience. Afterward, aluminum wire bonding is performed for the semiconductor chips 16a and 16b with aluminum wires. Further, the insulating substrate 3a is connected on the base plate 1 with low melting point solder such as (Pb-60wt%Sn) solder by heating the substrate 3a and the solder at 240 °C in an H₂ ambience.

Next, in the peripheral creepage surface zone of the insulating substrate 3a connected on the base plate 1, the surface of the substrate 3a, between the peripheral part of substrate 3a and the edge part of the electrode pattern sheet 3b, is covered with the resin 4 possessing a high withstand voltage. Moreover, the resin 4 with a high withstand voltage on the substrate 3a is cured by heating the resin 4 in a thermostatic oven (150 °C × 1h). Further, the leader-line terminals 9 and 10 are connected on the substrate 3a with solder paste such as (Pb-60wt%Sn) paste by heating the terminals 9 and 10 and the solder paste at 240 °C. The insulating resin case member 6 is adhered to the peripheral part of the base plate 1 with the adhesive 7 shown in Fig. 13. Furthermore, the surface of the base plate 1, between the case member 6 and the edge part of the insulating substrate 3a covered with resin 4, is further covered with the resin 37 possessing a high withstand voltage. Afterward, the insulating silicone-gel material 5b is poured into the case member 6 so that a space 11 remains under the terminal block 8 provided as a cover of the case member 6. Moreover, after the degassing process is performed for the poured silicone-gel material 37 (1 Trr × 80 m), the silicon gel material 37 is heated and cured (150 °C × 2 h). Thus, the fabrication of the semiconductor device is completed.

In this device, since the peripheral part of the insulating substrate 3a, and the surface of the base plate 1, which surrounds the peripheral part of the substrate 3a, are covered with the insulating resin 37, the withstand voltage can be further improved. Especially, in this embodiment, since the resin 37 whose dielectric breakdown voltage is higher than that of the insulating-gel material 5a and 5b is used, the withstand voltage is greatly improved. Moreover, since the creepage region between the edge part of the electrode pattern sheet 3b and the periphery of the insulating substrate 3a is covered with the resin 4, the resin 37 covering the surface of the base plate 1 does not flow or extend onto the insulating substrate 3a or the electrode pattern sheet 3b. That is, the electrode pattern sheet 3b is surrounded by the annular cover zone of the resins 4, and does not contact the resin 37. Therefore, each stress generated at interfaces among the resin 37, the base plate 1, and the insulating plate 3a is mitigated, which decreases the probability of occurrence of a separation in the semiconductor device. Thus, the dielectric breakdown voltage is not easily degraded, and the reliability of the semiconductor device is improved.

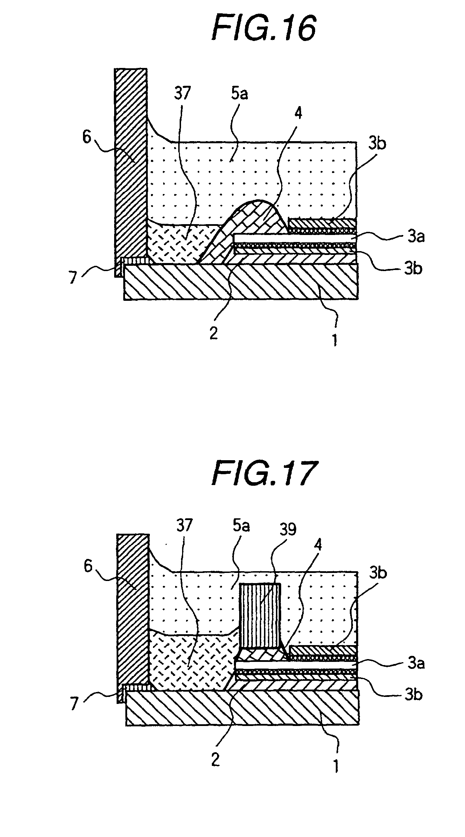

Fig. 16 is a partial cross-sectional view of another power semiconductor device. In this device, the creepage surface of the insulating substrate 3a, and a partial zone of the surface of the base plate 1, surrounding the substrate 3a, are covered with the resin 4 with possessing a high withstand voltage, and the resin 4 is cured. Moreover, the remaining surface of the base plate 1, between the case member 6 and the resin 4, is further covered with the resin 37 possessing high withstand voltage. Also, it is desirable that the shape and size of the electrode pattern sheet 3b attached at the edge of the base plate 1 is almost the same as that of the insulating substrate 3a. According to this structure, the intrusion of the resin 4 into the gap between the substrate 3a and the base plate 1 - that is, the space under the back surface of the substrate 3a- can be prevented. Therefore, the break at the edge part of the insulating substrate 3a due to the intrusion of the resin 4 can be prevented.

Thus, this semiconductor device possesses almost the same dielectric breakdown voltage as that of the device shown in Fig. 13.

Fig. 17 is a partial cross-sectional view of a power semiconductor device of another embodiment according to the present invention, and the whole composition of the semiconductor device of this embodiment is almost the same as that of the device shown in Fig. 15.

In this embodiment, an insulating resin frame 39 is connected on the peripheral creepage zone of the insulating substrate 3a with the rein 4 possessing a high withstand voltage, and the surface of the base plate 1, between the frame 39 and the case member 6, is covered with the resin 37 possessing a high withstand voltage, similar to the embodiment shown in Fig. 16.

By using the insulating resin (for example, PPS-resin) or ceramics frame 39 whose cross-sectional shape is almost equal to that of the peripheral creepage zone of the substrate 3a, it is possible to secure the creepage distance longer than twice of that in the conventional structure. Moreover, the surface of the base plate 1, between the case member 6 and the frame 39 is thickly covered with the resin 37 possessing a high withstand voltage. Thus, the dielectric breakdown voltage between the insulating substrate 3a and the base plate 1 is greatly increased.

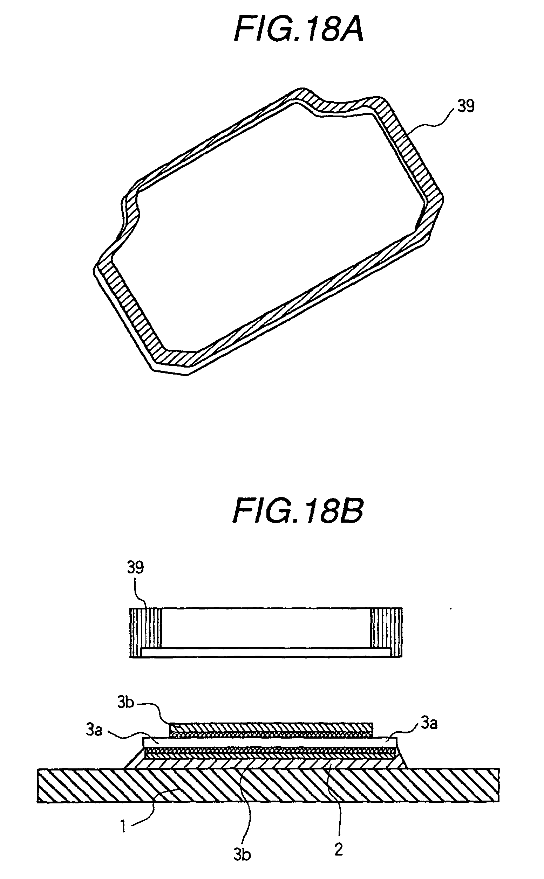

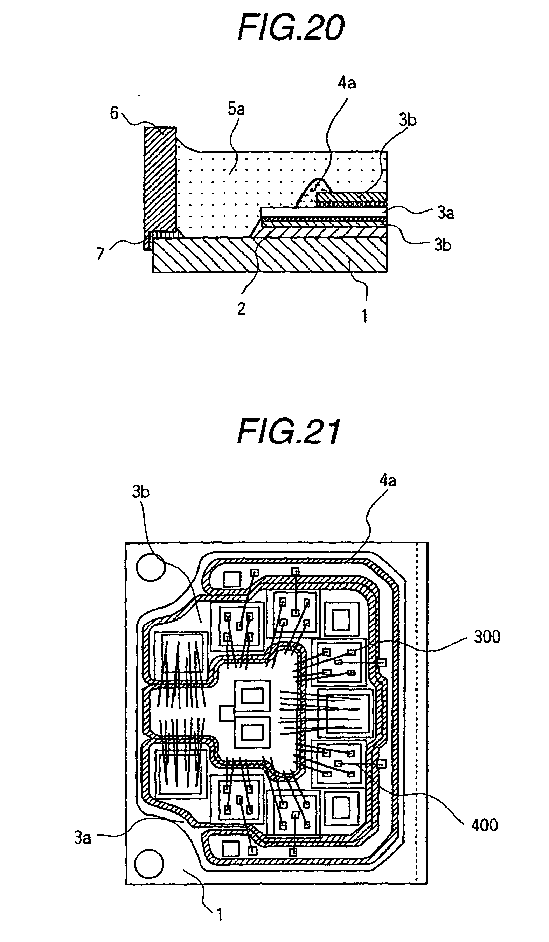

Fig. 18A is a perspective view of the insulating resin (for example, PPS-resin) or ceramic frame 39 in the semiconductor device of the embodiment shown in Fig. 17, and Fig. 18B shows cross-sectional views of the insulating resin frame 39 and the insulating substrate 3a mounted on the base plate 1. Further, Fig. 19 shows cross-sectional views of a modified insulating resin frame 39 and the insulating substrate 3a mounted on the base plate 1, which corresponds to Fig. 18B.

As shown in Fig. 19, projection parts 39a are provided on the back surface of the insulating resin frame 39, the back surface corresponding to the peripheral zone of the insulating substrate 3a. Accordingly, the frame 39 can be easily positioned on the peripheral zone of the substrate 3a, which certainly secures the creepage distance of the insulating substrate 3a. Moreover, by providing three or more projection parts on the back surface of the frame 39, the distance between the back surface of the frame 39 and the peripheral surface of the insulating substrate 3a - that is, the thickness of the resin 4 with a high withstand voltage - can be kept constant, which results in the high adhesive strength in the connection between the frame 39 and the substrate 3a. Thus, a more reliable insulating-withstand-voltage-structure can be realized for the semiconductor device.

Here, the withstand voltage of material used for the insulating substrate 3a in the conventional semiconductor device and that in the device according to the present invention is expressed by the dielectric breakdown voltage of 10 - 13 kVrms. Also, the dielectric breakdown voltage of the gel resin 5a (5b) which is used in the above two types of devices is about 14 kVrms. Therefore, the maximum withstand voltage is about 14 kVrms in the conventional semiconductor device.

On the other hand, in the semiconductor device of the embodiment according to the present invention, the creepage region of the insulating substrate 3a, between the peripheral part of the substrate 3a and the edge part of the electrode pattern sheet 3b, is covered with the resin 4 possessing a high withstand voltage (high dielectric breakdown voltage). Furthermore, also in other embodiments, the surface of the base plate 1, between the case member 6 and the periphery of the insulating substrate 3a, is covered with the resin 4 possessing a high withstand voltage, or the insulating resin frame 39 is attached on the peripheral creepage zone of the insulating substrate 3a. Thus, according to the semiconductor device of the present invention, it has become possible to obtain a withstand voltage (about 16 kVrms) higher than that in the conventional semiconductor device. It indicates that while the dielectric breakdown occurs in the bulk of the gel resin or at the interface between the insulating substrate 3a and the gel resin in the conventional structure, the dielectric breakdown passes through the resin 4 with a high withstand voltage or the breakdown occurs in the substrate 3a in the structure according to the present invention. Therefore, in accordance with the present invention, greatly larger effects to increase the withstand voltage can be obtained in comparison with the measure of geometrically increasing the creepage distance of the insulating substrate 3a in the conventional structure. Thus, the semiconductor device with a high withstand voltage can be obtained without increasing the size of the insulating substrate.

In the following, other device will be explained in detail with reference to Fig. 20 - Fig. 26.

Fig. 20 is a partial cross-sectional view of a power semiconductor device, and Fig. 21 is a plan view of semiconductor circuits composed on an aluminum nitride substrate in the power semiconductor device.

As shown in Fig. 20 and Fig. 21, electrode pattern sheets 3b (for example, Cu thin films) are soldered on the top and back surfaces of the insulating substrate 3a made of insulating material such as aluminum nitride (AlN), with Ag solder such as Cu-Ag eutectic solder containing Ti, with the melting point of 800 - 850 °C. Further, the boundary part between the creepage surface of the substrate 3a and the edge part of the electrode pattern sheet 3b is covered with non-organic crystal glass 4a such as (Bi₂O₃-B₂O₃) glass, and the glass 4a is fused and fixed to the substrate 3a and the electrode pattern sheet 3b by heating the glass at 700 °C in atmosphere or N₂ gas. Moreover, the semiconductor chips 400 are attached on the electrode pattern sheet 3b with high melting point solder such as (Pb-5wt%Sn-1.5wt%Ag) solder with the melting point of 296 - 305 °C, and wiring is performed for the semiconductor chips 400 with aluminum wires 300. Further, the AlN insulating substrates 3a are attached on the base plate 1 made of metal such as Mo, composite material such as Al-SiC, or sintered material such as CuCuO₂, with solder 2, for example, (Sn-40 wt% Pb) solder with the melting point of 183 - 191 °C, by heating the substrates 3a and the solder in H₂ gas. Afterward, the case member 6 made of PPS insulating resin is attached around the peripheral part of the base plate 1 with silicone-resin adhesive 7. Last, after the insulating-gel resin 5a is poured into the case member 6, and is cured, the fabrication of the module-type semiconductor device is completed by sealing the upper aperture of the case member 6.

In this device, by covering the boundary part between the creepage surface of the substrate 3a and the edge part of the electrode pattern sheet 3b with non-organic crystal glass 4a such as (Bi₂O₃-B₂O₃) glass, since the dielectric breakdown voltage of the substrate 3a is higher than that of the insulating-gel resin 5a, and the breakdown development due to a partial discharge is suppressed, the withstand voltage between the edge part of the electrode pattern sheet 3b and the base plate 1 can be greatly increased.

Furthermore, since the insulating substrate 3a soldered on the base plate 1 is made of ceramics, the frame positioned and connected around the peripheral creepage region of the insulating substrate 3a is made of the same resin making the case member 6 or ceramics similar to that making the insulating substrate 3a, the high withstand voltage of the semiconductor device can be secured.

Here, material used for the base plate 1 is selected such that the thermal expansion coefficient of the base plate 1 on which the insulating substrate 3a is soldered, the electrode pattern sheet 3b being attached on the insulating substrate 3a, is less than three times of that of silicon (Si). Accordingly, in the operation state of the semiconductor device, the difference between thermal expansion coefficients of the substrate 3a and the base plate 1 can be reduced, and the thermal stress applied to the solder 2 can be also mitigated, which realizes a highly reliable semiconductor device.

Moreover, as mentioned above, metal such as Mo, composite material such as Al-SiC, sintered material such as CuCuO₂, and so on are desirable as material used for the base plate 1. By adopting the above structure or material, it has become possible to obtain a cheap and highly reliable power semiconductor device with a high withstand voltage.

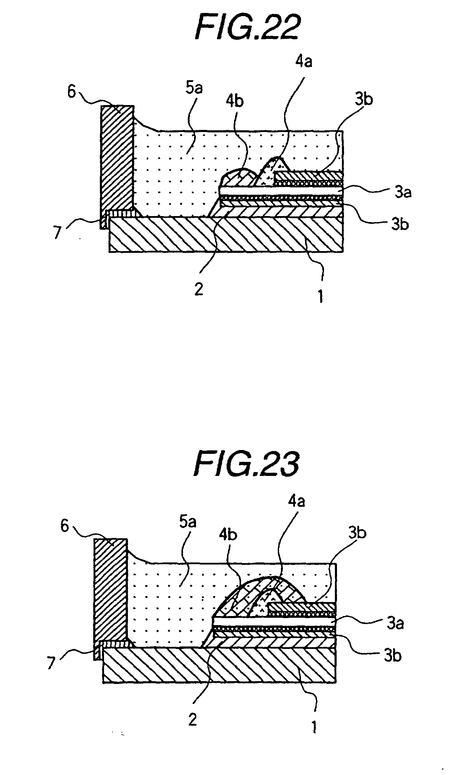

Figs. 22, 23, and 24 are partial cross-sectional views of other power semiconductor devices.

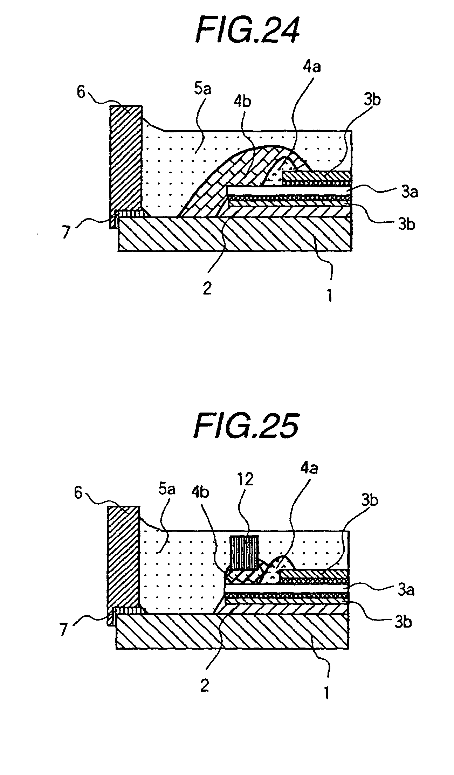

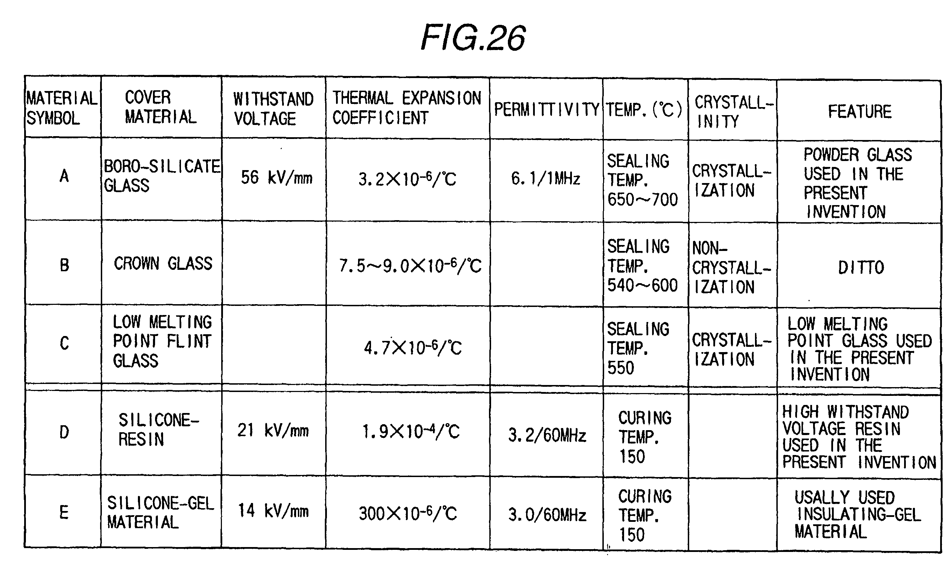

In the device shown in Fig. 22, the boundary part between the creepage surface of the substrate 3a and the edge part of the electrode pattern sheet 3b is covered with non-organic crystal glass 4a such as (Bi₂O₃-B₂O₃) glass, and the remaining creepage surface of the substrate 3a is covered with silicone-resin 4b of high insulating-withstand-voltage resin shown by symbol D in Fig. 26. Secondly, in the device shown in Fig. 23, the boundary part between the creepage surface of the substrate 3a and the edge part of the electrode pattern sheet 3b with non-organic crystal glass 4a such as (Bi₂O₃-B₂O₃) glass, and the region including both the boundary part covered with the crystal glass 4a and the remaining creepage surface of the substrate 3a is further covered with silicone-resin 4b of high insulating-withstand-voltage resin shown by symbol D in Fig. 26. Last, in the device shown in Fig. 24, the region including both the boundary part and the remaining creepage surface which are shown in Fig. 23 and at least a part of the surface of the base plate 1, outside the periphery of the substrate 3a, are covered with silicone-resin 4b with high insulating-withstand-voltage.

According to the structure of the semiconductor device shown in Fig. 22, the breakdown development due to local-discharge in the creepage surface of the AlN insulating substrate 3a can be suppressed by the two-step barriers 4a and 4b, which further increases the withstand voltage. Next, according to the structure of the semiconductor device shown in Fig. 23, in addition to increase of the withstand voltage due to elongation of the creepage distance in the substrate 3a, the non-organic cover 4a on the boundary part between the substrate 3a and the conductive sheet 3b is protected by the insulating resin 4b, and the withstand voltage is further increased by the double barriers 4a and 4b. Last, according to the structure of the semiconductor device shown in Fig. 24, the withstand voltage in the partial surface of the base plate 1, surrounding the periphery of the substrate 3a, can be also additionally obtained.

In the three types of the structures shown in Figs. 22, 23, and 24, the potential concentration at the edge part of the electrode pattern sheet 3b is mitigated by the first layer of the non-organic cover 4a, and the region neighboring or surrounding the non-organic cover 4a is protected by the second layer of the insulating resin 4b. Thus, the breakdown development due to the local-discharge in the creepage surface of the AlN insulating substrate 3a can be sufficiently suppressed, which brings the very high withstand voltage to the semiconductor device.

On top of that, silicone-resin or polyamide-resin, which well adheres to the creepage surface of the AlN insulating substrate 3a and is easily obtained, is used for the resin 4a with a high withstand voltage. Therefore, the semiconductor device can be easily and cheaply fabricated.

Fig. 25 is a partial cross-sectional view of a power semiconductor device of another embodiment according to the present invention. In this embodiment, after the boundary part between the creepage surface of the substrate 3a and the edge part of the electrode pattern sheet 3b is covered with non-organic glass 4a, the insulating frame 12 made of PPS-resin or ceramics is adhered on the remaining creepage zone in the peripheral part of the insulating substrate 3a with the silicone-resin 4b possessing a high withstand voltage.

According to this embodiment, the creepage distance of the insulating substrate 3b can be elongated by more than twice, which can realize the semiconductor device with the withstand voltage greatly higher than that of the conventional semiconductor device.

Thus, in accordance with the present invention, the reliability in the withstand voltage of a semiconductor device can be greatly improved.

## Claims

1. A semiconductor device comprising:
a base plate (1);
at least one insulating plate (3a) with at least one conductive member (3b) attached on the top surface of said insulating plate (3c), the back surface of said insulating plate (3c) being mounted on a surface of said base plate (1);
a case (6) surrounding said insulating plate (3a);
semiconductor elements contained in said case (6) and supported by the insulating plate (3a); and
first resin(5a) with which said case (1) is filled;
wherein a region between the edge part of said conductive member (3b) and the peripheral part of said insulating plate (3c) is covered with second resin (4), and the outside edge of said second resin (4) is located within said peripheral part of said insulating plate (3a), such that the second resin (4) does not contact the base plate (1);
**characterised in that**:
the device further includes an insulating frame (12a) adhered on said second resin (4); or
an insulating resin sheet (13) adhered on a surface region of said insulating plate (3a), between said edge part of said conductive member (3b) and said peripheral part of said insulating plate (3a), and said surface region including said resin sheet is covered with said second resin (4).

2. Semiconductor device according to claim 1, wherein said edge part of said conductive member (3b) is covered with said second resin (4).

3. A semiconductor device according to claim 1, wherein the dielectre breakdown voltage of said second resin (4) is higher than that of said first resin (5c).

4. A semiconductor device according to claim 3, wherein the distance between said edge part of said conductive member (3b) and said peripheral part of said insulating plate (3a) is larger than the thickness of said insulating plate (3a).

5. A semiconductor device according to claim 1, wherein the whole region between the periphery of said insulating plate (3a) and said edge part of said conductive member (3b) is covered with said second resin (4).

6. A semiconductor device according to claim 1, wherein said first resin (5c) is gel resin, said case possesses a cover (8), and there is a space between the surface of said gel resin and said cover (8).

7. A semiconductor device according to claim 1, wherein said peripheral part of said insulating plate (3a) is partially covered with said second resin (4) at a plurality of parts including at least corners of said peripheral part of said insulating plate (3a).

## Patentansprüche

1. Halbleitervorrichtung, aufweisend
eine Grundplatte (1),
mindestens eine Isolierplatte (3a), auf deren oberer Fläche mindestens ein leitfähiges Element (3b) angebracht ist und deren rückwärtige Fläche auf einer Fläche der Grundplatte (1) befestigt ist,
ein die Isolierplatte (3a) umgebendes Gehäuse (6),
in dem Gehäuse (6) enthaltene und von der Isolierplatte (3a) getragene Halbleiterelemente, und
ein erstes Harz (5a), das das Gehäuse (6) füllt,
wobei ein Bereich zwischen dem Kantenteil des leitfähigen Elements (3b) und dem Umfangsteil der Isolierplatte (3c) mit einem zweiten Harz (4) bedeckt ist, dessen Außenkante innerhalb des Umfangsteils der Isolierplatte (3a) liegt, so daß es die Grundplatte (1) nicht berührt,
**dadurch gekennzeichnet, daß**
die Vorrichtung außerdem einen auf dem zweiten Harz (4) haftenden Isolierrahmen (12a); oder eine auf einem Oberflächenbereich der Isolierplatte (3a) zwischen dem Kantenteil des leitfähigen Elements (3b) und dem Umfangsteil der Isolierplatte (3a) haftende isolierende Harzlage (13), wobei der Oberflächenbereich mit der Harzlage von dem zweiten Harz (4) bedeckt ist, beinhaltet.

2. Vorrichtung nach Anspruch 1, wobei der Kantenteil des leitfähigen Elements (3b) mit dem zweiten Harz (4) bedeckt ist.

3. Vorrichtung nach Anspruch 1, wobei die dielektrische Durchbruchsspannung des zweiten Harzes (4) größer als die des ersten Harzes (5c) ist.

4. Vorrichtung nach Anspruch 3, wobei der Abstand zwischen dem Kantenteil des leitfähigen Elements (3b) und dem Umfangsteil der Isolierplatte (3a) größer als die Dicke der Isolierplatte (3a) ist.

5. Vorrichtung nach Anspruch 1, wobei der gesamte Bereich zwischen dem Umfang der Isolierplatte (3a) und dem Kantenteil des leitfähigen Elements (3b) mit dem zweiten Harz (4) bedeckt ist.

6. Vorrichtung nach Anspruch 1, wobei das erste Harz (5c) ein Gelharz ist, das Gehäuse eine Abdeckung (8) aufweist und zwischen der Oberfläche des Gelharzes und der Abdeckung (8) ein Raum vorgesehen ist.

7. Vorrichtung nach Anspruch 1, wobei der Umfangsteil der Isolierplatte (3a) an mehreren Teilen, zumindest einschließlich Ecken des Umfangsteils der Isolierplatte (3a), teilweise mit dem zweiten Harz (4) bedeckt ist.

## Revendications

1. Dispositif à semi-conducteurs, comprenant :
une embase (1) ;
au moins une plaque isolante (3a) avec au moins un élément conducteur (3b) fixé sur la surface supérieure de ladite plaque isolante (3c), le dos de ladite plaque isolante (3c) étant monté sur une surface de ladite embase (1) ;
un boîtier (6) entourant ladite plaque isolante (3a) ;
des éléments semi-conducteurs contenus dans ledit boîtier (6) et supportés par la plaque isolante (3a) ; et
une première résine (5a) dont est rempli ledit boîtier (1) ;
une région entre la partie formant bord dudit élément conducteur (3b) et la partie périphérique de ladite plaque isolante (3c) étant couverte par une deuxième résine (4), et le bord extérieur de ladite deuxième résine (4) se trouvant à l'intérieur de ladite partie périphérique de ladite plaque isolante (3a), de façon que la deuxième résine (4) ne touche pas la plaque de base (1) ;
**caractérisé en ce que** :
le dispositif comprend en outre un cadre isolant (12a) collé sur ladite deuxième résine (4) ; ou une feuille de résine isolante (13) collée sur une région de surface de ladite plaque isolante (3a), entre ladite partie formant bord dudit élément conducteur (3b) et ladite partie périphérique de ladite plaque isolante (3a), et ladite région de surface comportant ladite feuille de résine est couverte par ladite deuxième résine (4).

2. Dispositif à semi-conducteurs selon la revendication 1, dans lequel ladite partie formant bord dudit élément conducteur (3b) est couverte par ladite deuxième résine (4).

3. Dispositif à semi-conducteurs selon la revendication 1, dans lequel la tension disruptive de ladite deuxième résine (4) est supérieure à celle de ladite première résine (5c).

4. Dispositif à semi-conducteurs selon la revendication 3, dans lequel la distance entre ladite partie formant bord dudit élément conducteur (3b) et ladite partie périphérique de ladite plaque isolante (3a) est plus grande que l'épaisseur de ladite plaque isolante (3a).

5. Dispositif à semi-conducteurs selon la revendication 1, dans lequel toute la région entre le pourtour de ladite plaque isolante (3a) et ladite partie formant bord dudit élément conducteur (3b) est couverte par ladite deuxième résine (4).

6. Dispositif à demi-conducteurs selon la revendication 1, dans lequel ladite première résine (5c) est une résine sous forme de gel, ledit boîtier possède un couvercle (8) et un espace est présent entre la surface de ladite résine en forme de gel et ledit couvercle (8).

7. Dispositif à semi-conducteurs selon la revendication 1, dans lequel ladite partie périphérique de ladite plaque isolante (3a) est partiellement couverte par ladite deuxième résine (4) en plusieurs endroits dont au moins des angles de ladite partie périphérique de ladite plaque isolante (3a).
